# EUROPEAN PATENT APPLICATION

(11) **EP 2 515 351 A1**
(43) Date of publication of application: **24.10.2012**
(21) Application number: 10837561.9
(22) Date of filing: 13.12.2010
(51) Int. Cl.: H01L 31/052

(54) **SOLAR POWER GENERATION APPARATUS**

(30) Priority: 16.12.2009 JP 2009285435
(71) Applicant: NEC Corporation, Tokyo 108-8001 (JP)
(72) Inventor: NAKAYA, Shogo, Tokyo 108-8001 (JP)
(74) Representative: Betten & Resch
(86) International application number: PCT/JP2010/072382
(87) International publication number: WO 2011/074535

(57) **Abstract**

A solar power generation apparatus can generate power at a high efficiency with less light loss. A solar power generation apparatus in which a solar cell unit is disposed at focal position in an optical system, which is composed of a single optical system and formulated so as to collect and spectrally separate incident light that falls in parallel to an optical axis, and focus each of the spectrally separated wavelength band lights at a different focal position on the optical axis. The solar cell unit includes a plurality of solar cells, each including, a junction unit disposed on a circumference of a substrate portion disposed along the optical axis, a surface of the junction portion forming a light receiving surface with a different sensitive wavelength band. The plurality of solar cells are arrayed along the optical axis, and each of the solar cells is disposed at one of the focal positions at which the wavelength band light corresponding to each the different sensitive wavelength band is focused.

## Description

### TECHNICAL FIELD

### (DESCRIPTION OF RELATED APPLICATION)

This application claims the benefit of Japanese Patent Application No. 2009-285435, filed December 16, 2009, which is hereby incorporated by reference herein in its entirety.

This invention relates to a solar power generation apparatus having light collection means, and particularly relates to a solar power generation apparatus using a chromatic aberration.

### BACKGROUND ART

A solar power generation apparatus has been focused as clean energy source, since it does not generate air pollution gas, and it is easy to use it. Since a solar cell that is a constituent element of a solar power generation apparatus is expensive, an effective power generation is desired. As an example of a high efficient solar power generation apparatus, there is a concentrated solar power generation apparatus in which a solar cell generates power at high efficiency by causing a highly concentrated light to fall on the solar cell (e.g., Patent Literatures PTLs 1-3). According to the concentrated solar power generation apparatus, a high efficient power generation can be realized using light collection means such as a lens, which makes it possible to reduce number of solar cells that are used and area of solar cells that are used, so that the total cost of the apparatus can be reduced.

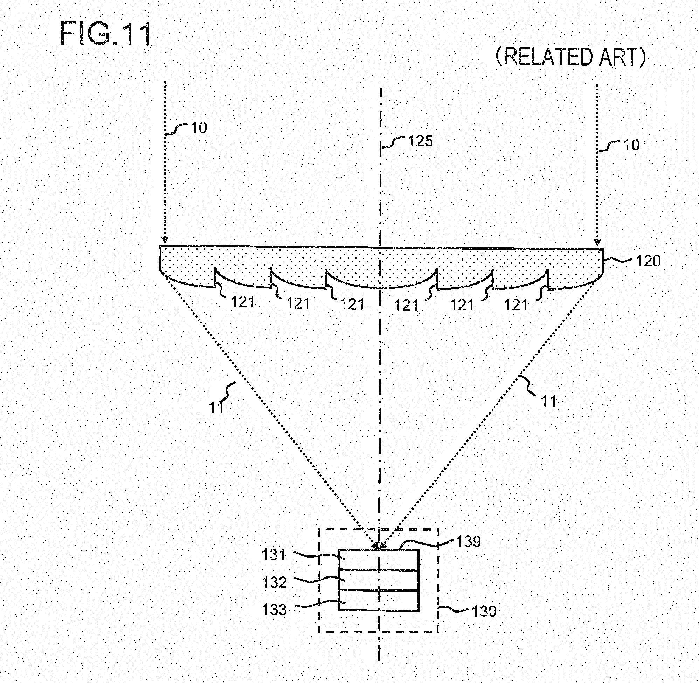

Such a concentrated solar power generation apparatus in a prior art is illustrated in Fig. 11. Incident solar light 10 impinges a condenser lens 120 in parallel to an optical axis 125 of the condenser lens 120. Collected light 11 collected by the condenser 120 is focused on a light receiving surface 139 of a solar cell unit 130 disposed perpendicular to the optical axis 125. The solar cell unit 130 is a cell in which a plurality of solar cells 131, 132 and 133 having different sensitive wavelength bands respectively are piled up. An inexpensive Fresnel lens is used for the condenser lens 120 in many cases. Grooves 121 of the Fresnel lens are formed on the surface of the solar cell unit 130 side of the condenser lens 120.

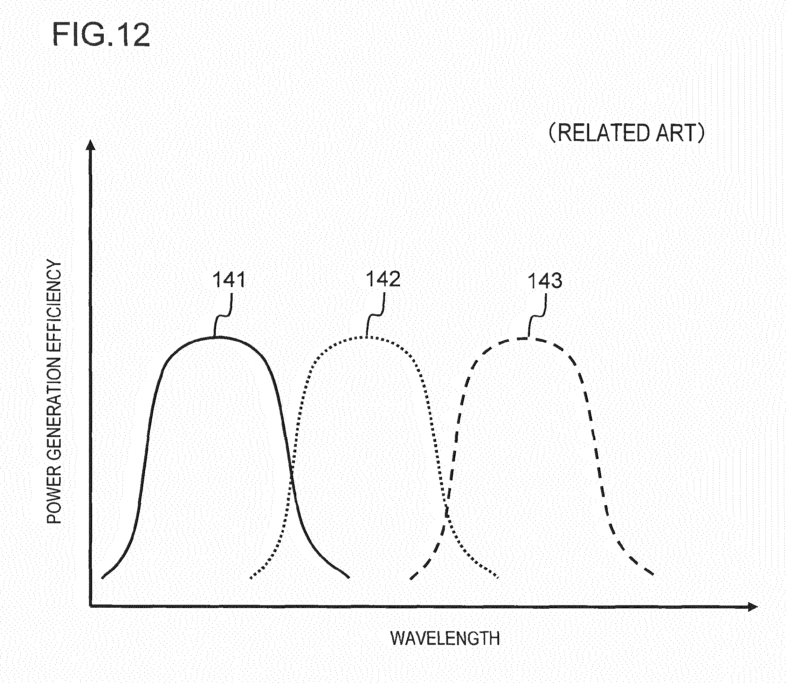

Curves 141, 142 and 143 in Fig. 12 show light wavelength dependence of power generation efficiency in solar cells 131, 132 and 133 of Fig. 11, respectively. Although solar light has broad spectrum, a solar cell with single junction can use only part of the spectrum for photoelectric conversion. For this reason, there is a solar cell unit in which a plurality of solar cells having different sensitive wavelength bands respectively are piled up so that the broad spectrum is used for photoelectric conversion. A compound semiconductor that has high efficiency but high cost is used for such a piled up type solar cell in many cases. In order to realize low cost by reducing usage of the expensive compound semiconductor, a method is often used that performs photoelectric conversion in a state that light receiving area becomes smaller by collecting solar light using a condenser lens.

### CITATION LIST

### PATENT LITERATURE

[PTL 1]
   Japanese Patent Kokai Publication No. JP-S58-77262A
[PTL 2]
   Japanese Patent Kokai Publication No. JP-S61-164272A
[PTL 3]
   Japanese Patent Kokai Publication No. JP2004-146751A

### SUMMARY OF INVENTION

### TECHNICAL PROBLEM

The disclosures of above cited Patent Literatures are incorporated herein in their entirety by reference thereto. The following analysis is given according to the view of the present invention.

The conventional piled up type solar cell has a problem in which some incident light entering from a light receiving surface is lost due to scattering, absorption, or reflection at an interface(s) as the incident light proceeds inside the solar cell. For this reason, there is a problem in which power generation efficiency cannot be improved.

It is a principal object of the present invention to provide a solar power generation apparatus which can realize high efficient power generation with low light loss.

### SOLUTION TO PROBLEM

In a first aspect of the present invention, there is provided a solar power generation apparatus in which a solar cell unit is disposed at a focal position in an optical system. The optical system is composed of a single optical system and formulated so as to collect and spectrally separate incident light that falls in parallel to an optical axis of the optical system, and focus each of the spectrally separated wavelength band lights at a different focal position on the optical axis. The solar cell unit includes a plurality of solar cells, each of which includes a junction portion disposed on a circumference of a substrate portion disposed along the optical axis, a surface of the junction portion forming a light receiving surface with a different sensitive wavelength band. The plurality of solar cells are arrayed along the optical axis, and each of the solar cells is disposed at one of the focal positions at which the wavelength band light corresponding to each the different sensitive wavelength band is focused.

In the solar power generation apparatus of the present invention, it is preferred that the substrate portion is formed as a cylindrical or columnar body disposed along the optical axis; and the junction portion is formed in a cylindrical surface or tubular shape on a side surface(s) of the cylindrical or columnar body.

In the solar power generation apparatus of the present invention, it is preferred that the substrate portion is formed as a conical or pyramid body whose vertex is directed toward the optical system; the junction portion is formed in a conical or pyramid shape on a side surface(s) of the conical or pyramid body.

In the solar power generation apparatus of the present invention, it is preferred that the optical system is a Fresnel lens having a lens portion comprising circular concentric grooves that have sidewall surfaces extending in parallel to the incident light.

In a second aspect of the present invention, there is provided a solar power generation apparatus in which a solar cell unit is disposed at a focal position in an optical system. The optical system is composed of a single optical system and formulated so as to collect and spectrally separate incident light that falls in a non-parallel direction to an optical axis of the optical system, and focus each of the spectrally separated wavelength band lights at a different focal position on a predetermined line excluding the optical axis. The solar cell unit includes a plurality of solar cells, each of which includes a planar junction portion on a surface of a substrate portion, a surface of the junction portion forming a light receiving surface with a different sensitive wavelength band. The plurality of solar cells are arrayed along the predetermined line, and each of the solar cells is disposed at one of the focal positions at which the wavelength band light corresponding to each the different sensitive wavelength band is focused.

In the solar power generation apparatus of the present invention, it is preferred that the optical system is a Fresnel lens having a lens portion comprising circular grooves that have sidewall surfaces extending in parallel to the incident light.

In the solar power generation apparatus of the present invention, it is preferred that the Fresnel lens has a flat surface portion at an opposite surface of the lens portion; the flat surface portion is a surface perpendicular to the incident light.

In the solar power generation apparatus of the present invention, it is preferred that the Fresnel lens has at least one step portion, each of which includes a flat surface portion perpendicular to the incident light and a groove having a sidewall surface extending in parallel to the incident light.

### EFFECT OF THE INVENTION

According to the present invention, it is possible to realize photoelectric conversion with higher efficiency than the conventional solar generation apparatus. The reason is that collection of light and spectral separation of light are performed with a single optical system through chromatic aberration (axial chromatic aberration, lateral chromatic aberration) of the optical system, and a plurality of solar cells having different sensitive wavelength bands are arrayed on focal positions that correspond to respective wavelength band lights. By this formulation, the light of all the wavelength bands is photoelectrically converted at the first junction portion of the solar cell (the nearest junction portion from the surface). Thus, since the loss due to penetration of the incident light through the other solar cell(s) does not occur, it is possible to realize solar power generation with higher efficiency than the conventional piled up type solar cell.

### BRIEF DESCRIPTION OF THE DRAWINGS

Fig. 1 is a schematic perspective view schematically showing a structure of a solar power generation apparatus in accordance with a first exemplary embodiment of the present invention;
Fig. 2 is a cross-sectional view taken along an optical axis schematically showing the structure of the solar power generation apparatus in accordance with the first exemplary embodiment of the present invention;
Fig. 3 is a cross-sectional view taken along a surface perpendicular to the optical axis schematically showing a structure of a solar cell unit of the solar power generation apparatus in accordance with the first exemplary embodiment of the present invention;
Fig. 4 is a cross-sectional view taken along an optical axis schematically showing a structure of a solar power generation apparatus in accordance with a second exemplary embodiment of the present invention;
Fig. 5 is a cross-sectional view taken along an optical axis schematically showing a structure of a solar power generation apparatus in accordance with a third exemplary embodiment of the present invention;
Fig. 6 is a plan view viewed from a light receiving surface side schematically showing a structure of a solar cell unit of the solar power generation apparatus in accordance with the third exemplary embodiment of the present invention;
Fig. 7 is a cross-sectional view taken along an optical axis schematically showing a structure of a solar power generation apparatus in accordance with a fourth exemplary embodiment of the present invention;
Fig. 8 is a schematic perspective view schematically showing a structure of a Fresnel lens of the solar power generation apparatus in accordance with the fourth exemplary embodiment of the present invention;
Fig. 9 is a cross-sectional view taken along an optical axis schematically showing a structure of a solar power generation apparatus in accordance with a fifth exemplary embodiment of the present invention;
Fig. 10 is a plan view viewed from a incident light side schematically showing a structure of a Fresnel lens of the solar power generation apparatus in accordance with the fifth exemplary embodiment of the present invention;
Fig. 11 is a cross-sectional view taken along an optical axis schematically showing a structure of a solar power generation apparatus in accordance with a related art; and
Fig. 12 is a graph schematically showing light wavelength dependence of power generation efficiency of a solar cell unit of the solar power generation apparatus in accordance with the related art.

### MODES FOR CARRYING OUT THE INVENTION

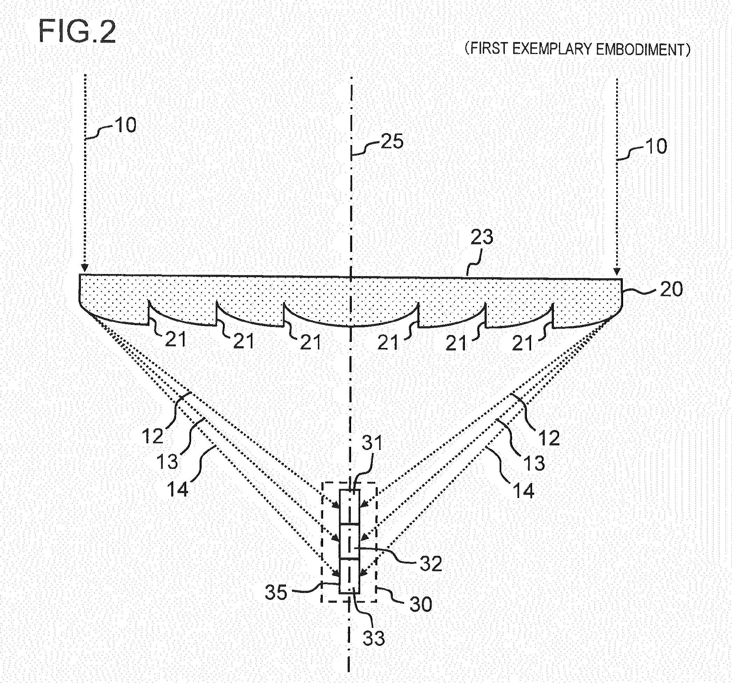

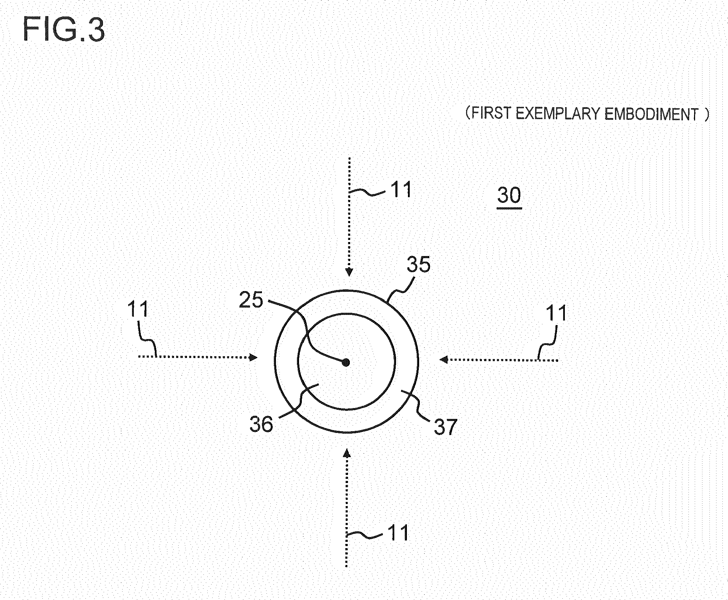

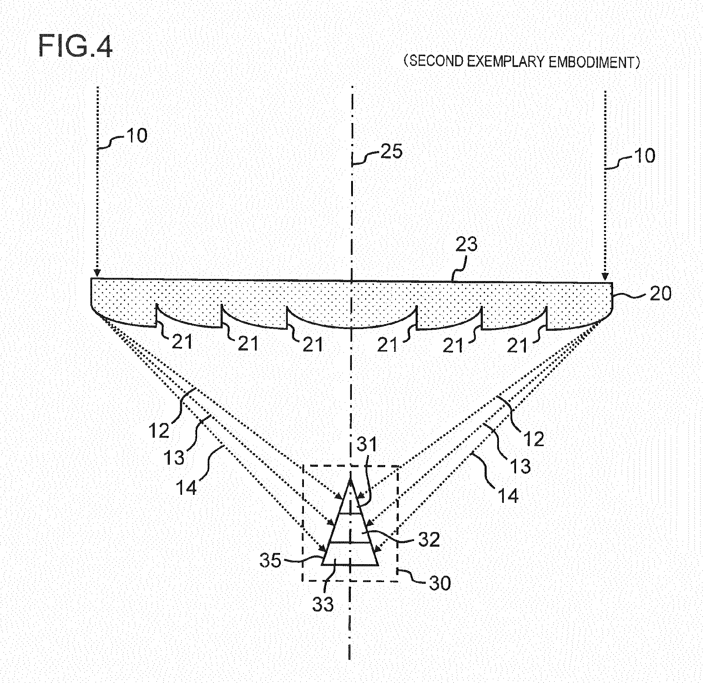

In an exemplary embodiment 1 of the present invention, there is provided a solar power generation apparatus in which a solar cell unit (30 in Figs. 2, 4) is disposed at a focal position in an optical system (20 in Figs. 2, 4), wherein the optical system is composed of a single optical system and formulated so as to collect and spectrally separate incident light (10 in Figs. 2, 4) that falls in parallel to an optical axis (25 in Figs. 2, 4) of the optical system, and focus each of the spectrally separated wavelength band lights (12, 13 and 14 in Figs. 2, 4) at a different focal position of the optical axis; the solar cell unit includes a plurality of solar cells, each of which includes a junction portion (37 in Fig. 3) disposed on a circumference of a substrate portion (36 in Fig. 3) disposed along the optical axis, a surface of the junction portion acting as a light receiving surface (35 in Figs. 2, 4) with a different sensitive wavelength band; and the plurality of solar cells (31, 32 and 33 in Figs. 2, 4) are arrayed along the optical axis, and each the solar cell is disposed at the focal position at which the wavelength band light corresponding to each of the sensitive wavelength bands is focused.

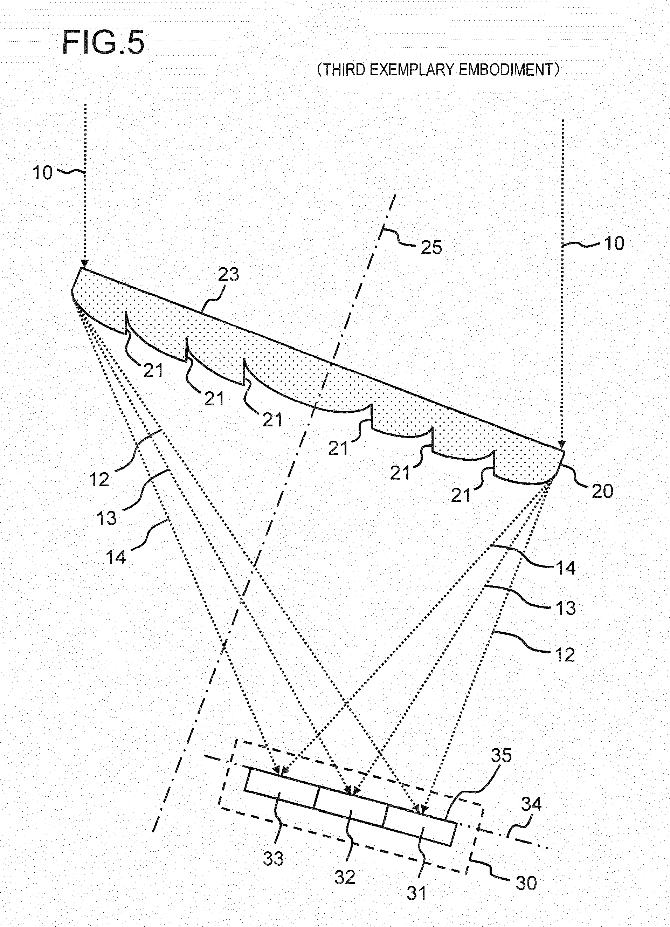

In an exemplary embodiment 2 of the present invention, there is provided a solar power generation apparatus in which a solar cell unit (30 in Figs. 5, 7 and 9) is disposed at a focal position in an optical system (20 in Figs. 5, 7 and 9), wherein the optical system is composed of a single optical system and formulated so as to collect and spectrally separate incident light (10 in Figs. 5, 7 and 9) that falls in a non-parallel direction to an optical axis (25 in Figs. 5, 7 and 9) of the optical system, and focus each of the spectrally separated wavelength band lights (12, 13 and 14 in Figs. 5, 7 and 9) at a different focal position of a predetermined line excluding the optical axis; the solar cell unit has a plurality of solar cells, each of which has a junction portion (corresponding to 37 in Fig. 3) on a surface of a substrate portion (corresponding to 36 in Fig. 3), a surface of the junction portion acting as a light receiving surface with a different sensitive wavelength band; and the plurality of solar cells (31, 32 and 33 in Figs. 5, 7 and 9) are arrayed along a predetermined line, and each of the solar cells is disposed at the focal position at which the wavelength band light corresponding to each of the sensitive wavelength bands is focused.

Furthermore, reference symbols to the drawings in the present application are shown only as examples in order to assist understanding, and are not intended to limit the present disclosure to the illustrated modes.

### (First Exemplary Embodiment)

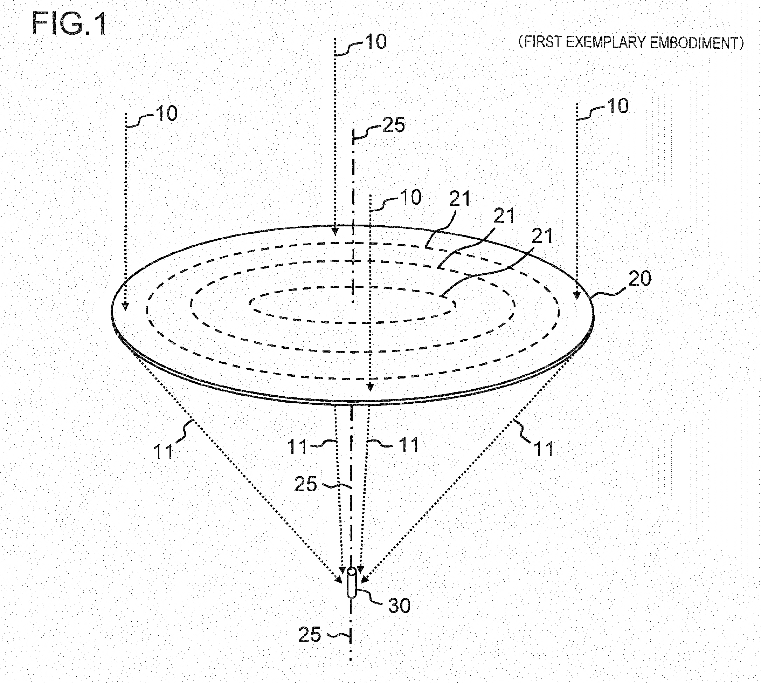

A solar power generation apparatus in accordance with a first exemplary embodiment of the present invention will be described with reference to drawings. Fig. 1 is a schematic perspective view schematically showing a structure of the solar power generation apparatus in accordance with the first exemplary embodiment of the present invention. Fig. 2 is a cross-sectional view taken along an optical axis schematically showing the structure of the solar power generation apparatus in accordance with the first exemplary embodiment of the present invention. Fig. 3 is a cross-sectional view taken along a surface perpendicular to the optical axis schematically showing a structure of a solar cell unit of the solar power generation apparatus in accordance with the first exemplary embodiment of the present invention.

With reference to Fig. 1, the solar power generation apparatus is a condensed solar power generation apparatus of a light-collection type in which a solar cell unit 30 is disposed at a focal position of a condenser lens 20.

The condenser lens 20 is a lens that collects solar light 10 which impinges in parallel to an optical axis 25. The condenser lens 20 is a lens having a light collection (condensor) function and a spectral separation function, and for instance, it is preferred that a light-in-weight and inexpensive Fresnel lens is used. A surface of an incident side of the condenser lens 20 is a flat surface portion 23; a surface of an emitting side (solar cell unit 30 side) of the condenser lens 20 is a convex surface that is convex at the central portion, and the convex surface has concentric circular grooves 21 whose center point is the optical axis 25 (see Fig. 2). Three grooves 21 are illustrated in Fig. 2, however, any number of grooves 21 is possible. Meanwhile, a circular condenser lens is shown as an example of the condenser lens 20 in Fig. 1, however, a rectangular lens is also possible. The condenser lens 20 uses a surface of an incident side as a flat surface portion 23, however, the condenser lens 20 may use a surface of an emitting side (solar cell unit 30 side) as the flat surface portion 23 by reversing the condenser lens 20.

The solar light 10 that impinges in parallel to the optical axis 25 of the condenser lens 20 is collected by passing through the condenser lens 20. Collected light 11 in Fig. 1 is not focused on a single point due to an axial chromatic aberration in a real situation. The collected light 11 that has passed through the condenser lens 20 is separated to respective wavelength band lights due to an axial chromatic aberration, so that respective wavelength band lights are focused on different positions of the optical axis 25. The aspect is shown in Fig. 2. Focal positions of respective wavelength band lights are placed in order of the focal position of short wavelength band light 12, the focal position of middle wavelength band light 13, and the focal position of long wavelength band light 14, from the condenser lens 20 side. This phenomenon in which light is focused on different points of the optical axis 25 depending on the wavelength of the light is known as the axial chromatic aberration.

A solar cell unit 30 is a device that directly converts light energy into electric power using a photovoltaic effect. The solar cell unit 30 is disposed at a focal position of the collected light 11 that has passed through the condenser lens 20. The solar cell unit 30 has a light receiving surface 35 that has a cylindrical surface shape with a small diameter at the circumference of the optical axis 25 of the condenser lens 20. The solar cell unit 30 includes a plurality of solar cells 31, 32 and 33 disposed along the optical axis 25 direction. A short wavelength band solar cell 31 is a solar cell having a sensitive wavelength band at the short wavelength region, and disposed at a focal position of short wavelength band light 12. A middle wavelength band solar cell 32 is a solar cell having a sensitive wavelength band at the middle wavelength region, and disposed at a focal position of middle wavelength band light 13. A long wavelength band solar cell 33 is a solar cell having a sensitive wavelength band at the long wavelength region, and disposed at a focal position of long wavelength band light 14. Respective circumference surfaces of the solar cells 31, 32 and 33 directly serve as a light receiving surface 35.

The solar cell unit 30 (solar cells 31, 32 and 33 in Fig. 2) has a substrate portion 36 along the optical axis 25 of the condenser lens (20 in Fig. 2), a junction portion 37 on the circumference of the substrate portion 36, and light receiving surface 35 on a surface of the junction portion 37 (see Fig. 3). The substrate portion 36 is formed as a cylindrical body (a post or columnar body is also possible) disposed along the optical axis 25. The junction portion 37 is formed as a cylindrical surface shape (a tubular shape is also possible) along a side surface of a cylindrical body (a post or columnar shape is also possible). Since light is photoelectrically converted at respective junction portions 37 just below the light receiving surface 35 of solar cells (31, 32 and 33 in Fig. 2), light loss due to the passing manner in which the incident light passes through the other cell(s) as occurring in the conventional apparatus does not occur, so that a high efficiency of photoelectric conversion can be realized. Meanwhile, since region near the optical axis 25 that becomes a focal position of the collected light 11 corresponds to a substrate portion 36 of the solar cell unit 30, the near-axis region cannot be used for photoelectric conversion. However, the affect can be suppressed by narrowing a diameter of the light receiving surface 35 of the solar cell unit 30 sufficiently.

The light receiving surface 35 is formed on the circumference of the optical axis 25 as a cylindrical surface shape (a tubular shape is also possible), and the light receiving surface 35 intersects the collected light 11 (respective wavelength band lights 12, 13 and 14 in Fig. 2) perpendicularly to the collected light on a cross-sectional surface perpendicular to the optical axis 25, whereas the light receiving surface 35 does intersect respective wavelength band lights 12, 13 and 14 (11 in Fig. 3) not perpendicularly to the collected light on a cross-sectional surface taken along the optical axis 25 as shown in Fig. 2. Therefore, in order to suppress reflection loss of the collected light 11 at the light receiving surface 35, it is preferred that the collected light 11 impinges on the light receiving surface 35 at an angle as nearly as possible to the perpendicular angle by shortening the focal distance of the condenser lens 20.

According to the first exemplary embodiment, it is possible to realize a higher efficiency of photoelectric conversion than the conventional solar power generation apparatus. The reason is that a single condenser lens 20 collects and spectrally separates light using the chromatic aberration of the condenser lens 20, and solar cells 31, 32 and 33 having a plurality of different sensitive wavelength bands respectively are disposed at the focal positions that correspond to respective wavelength band lights. By this constitution, all the wavelength band lights are photoelectrically converted at the junction portion 37 of the solar cells 31, 32 and 33. Thus, since light loss due to the passing manner in which the incident light passes through the other solar cell(s) does not occur, it is possible to realize solar power generation with higher efficiency than the conventional piled up type solar cell. Further, since a single condenser lens 20 has both the light collection function and the spectral separation function, the apparatus has a merit in which it is possible to realize a solar power generation apparatus with higher efficiency and lower light loss than an apparatus respectively comprising an optical system for light collection and an optical system for spectral separation.

### (Second Exemplary Embodiment)

A solar power generation apparatus in accordance with a second exemplary embodiment will be described with reference to drawings. Fig. 4 is a cross-sectional view taken along an optical axis schematically showing a structure of the solar power generation apparatus in accordance with the second exemplary embodiment of the present invention.

The second exemplary embodiment is a variant of the fist exemplary embodiment, in which solar cell unit 30 is formed as a conical body (a pyramid body is also possible) whose vertex is directed toward the condenser lens 20, instead of the cylindrical body. A cross-sectional surface of the solar cell unit 30 perpendicular to the optical axis 25 is the same as Fig. 3 (the first exemplary embodiment) except for the vertex of the conical body. The other constitution is similar to the first exemplary embodiment.

As viewed in a cross-sectional plane taken along the optical axis 25, the apparatus has a merit in which reflection loss can be suppressed, since the light receiving surface 35 having a conical shape in accordance with the second exemplary embodiment becomes closer to perpendicular to the proceeding directions of respective wavelength band lights 12, 13 and 14 than the light receiving surface (35 in Fig. 2) having a cylindrical surface shape in accordance with the first exemplary embodiment.. As an angle between a conical surface of the light receiving surface 35 and the optical axis 25 is larger, spectral separation of the collected light becomes unclear (not sharper), and the focal positions are not focused sharply. On the other hand, as an angle between a conical surface of the light receiving surface 35 and the optical axis 25 is larger, an incident angle of the collected light becomes smaller. That is, since the collected light (respective wavelength band lights 12, 13 and 14) impinges at an angle which is near the perpendicular angle to the receiving light surface 35, light loss due to reflection becomes smaller. Taking into account both factors, the angle between the conical surface of light receiving surface 35 and the optical axis 25 is set so as to get the highest efficiency of power generation.

According to the second exemplary embodiment, an effect similar to the first exemplary embodiment is obtained as well as light loss due to reflection can be suppressed, since the collected light (respective wavelength band lights 12, 13 and 14) impinges at a near perpendicular angle to the receiving light surface 35 by forming the light receiving surface 35 as a conical surface, and so it is possible to realize a higher efficient solar power generation than the first exemplary embodiment.

### (Third Exemplary Embodiment)

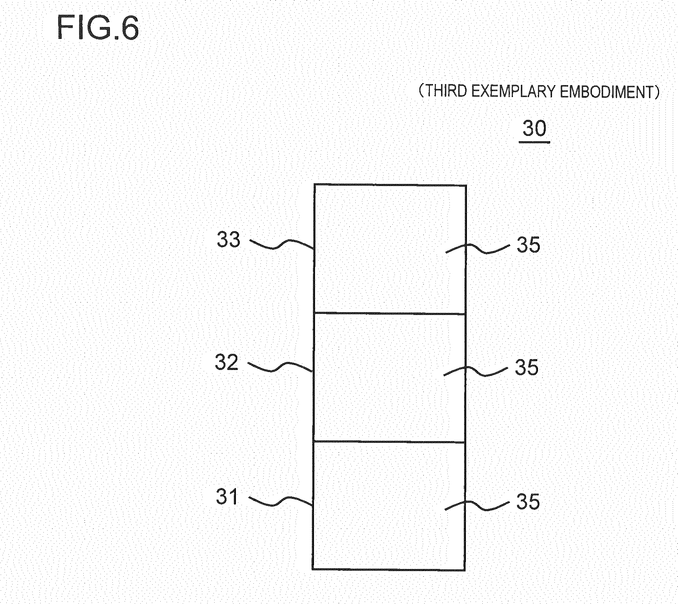

A solar power generation apparatus in accordance with a third exemplary embodiment will be described with reference to drawings. Fig. 5 is a cross-sectional view taken along an optical axis schematically showing a structure of the solar power generation apparatus in accordance with the third exemplary embodiment of the present invention. Fig. 6 is a plan view viewed from a light receiving side schematically showing the structure of a solar cell unit of the solar power generation apparatus in accordance with the third exemplary embodiment of the present invention.

The third exemplary embodiment is a variant of the first exemplary embodiment, in which an optical axis 25 of a condenser lens 20 is disposed at a certain tilted angle to the solar light 10 so that respective wavelength band lights 12, 13 and 14 are focused on different positions on a predetermined line 34 excluding the optical axis 25, and light receiving surfaces 35 of solar cells 33, 32 and 31 having a sensitivity at respective wavelength bands are disposed along a straight line. The other constitution is similar to the first exemplary embodiment.

The condenser lens 20 is a lens collecting solar light 10 that impinges in parallel to an optical axis 25. The condenser lens 20 is a lens having a light collection function and a spectral separation function, and for instance, it is preferred that a light-in-weight and inexpensive Fresnel lens is used for the condenser lens 20. A surface of an incident side of the condenser lens 20 is a planar surface portion 23; a surface of an emitting side (solar cell unit 30 side) of the condenser lens 20 is a convex surface that is convex at the central portion; the convex surface has concentric circular grooves 21 whose center is at the optical axis 25. Three grooves 21 are illustrated in Fig. 5, however, any number of grooves 21 is possible. Meanwhile, since solar light 10 that impinges at a deviated angle from the optical axis 25 is reflected and scattered at the grooves 21 when an ordinary Fresnel lens is used, there is a problem in which light loss is increased. So in the third exemplary embodiment, it is preferred that sidewall surfaces of the grooves 21 are set to be parallel to the incident light 10 as shown in Fig. 5, that is, a Fresnel lens in which the sidewall surfaces of the grooves 21 has a constant angle to the optical axis 25 is used. By this constitution, it is possible to suppress a phenomenon in which the incident solar light 10 is reflected and scattered at the grooves 21.

The optical axis 25 of the condenser lens 20 is tilted at a certain angle to the incident solar light 10. At this time, light that has passed through the condenser lens 20 is spectrally separated and collected to different points depending on respective wavelength band lights due to a lateral chromatic aberration to be focused on predetermined positions. In the case of the lateral chromatic aberration of the third exemplary embodiment that is different from the axial chromatic aberration of the first and second exemplary embodiment, focal positions of respective wavelength band lights 12, 13 and 14 are not on the optical axis 25 but on a predetermined line (on the light receiving surface 35 of a solar cell unit 30).

The solar cell unit 30 is an apparatus that converts light energy into electric power directly using photoelectric effect. The solar cell unit 30 is disposed at focal positions of respective wavelength band lights 12, 13 and 14 that have passed through the condenser lens 20. The solar cell unit 30 includes a plurality of solar cells 31, 32 and 33, and light receiving surfaces 35 of the solar cells 33, 32 and 31 having a sensitivity at respective wavelength band lights 12, 13 and 14 are disposed on a straight line (see Fig. 6). A short wavelength band solar cell 31 is a solar cell having a sensitive band at a short wavelength region, and disposed at a focal position of short wavelength band light 12. A middle wavelength band solar cell 32 is a solar cell having a sensitive band at a short wavelength region, and disposed at a focal position of middle wavelength band light 13. A long wavelength band solar cell 33 is a solar cell having a sensitive band at a short wavelength region, and disposed at a focal position of long wavelength band light 14. Flat surfaces of the condenser lens 20 side of the solar cells 31, 32 and 33 directly act as a light receiving surface 35.

The solar cell unit 30 (solar cells 31, 32 and 33) has a plate-shaped substrate portion (not shown), a flat junction portion (not shown) on the surface of the condenser lens 20 side of the substrate portion, and the flat light receiving surface 35 on a surface of the junction portion. Since light is photoelectrically converted at respective junction portions just below the receiving light surface 35 of the solar cells 31, 32 and 33, light loss due to the passing manner in which the incident light passes through the other solar cells as in the conventional apparatus does not occur, so that a high efficiency of photoelectric conversion can be realized. And since the light receiving surface 35 can be disposed at an angle near the perpendicular angle to respective wavelength band lights 12, 13 and 14, there is a merit of low reflection loss.

According to the third exemplary embodiment, there is an effect identical to the first exemplary embodiment. Additionally, light loss due to scattering and reflection can be suppressed by using an inexpensive and light-in-weight Fresnel lens as the condenser lens 20, and letting sidewall surfaces of the grooves 21 of the Fresnel lens parallel to solar light 10 even though a Fresnel lens whose grooves 21 are tilted at an angle T to the optical axis 25 is used.

### (Fourth Exemplary Embodiment)

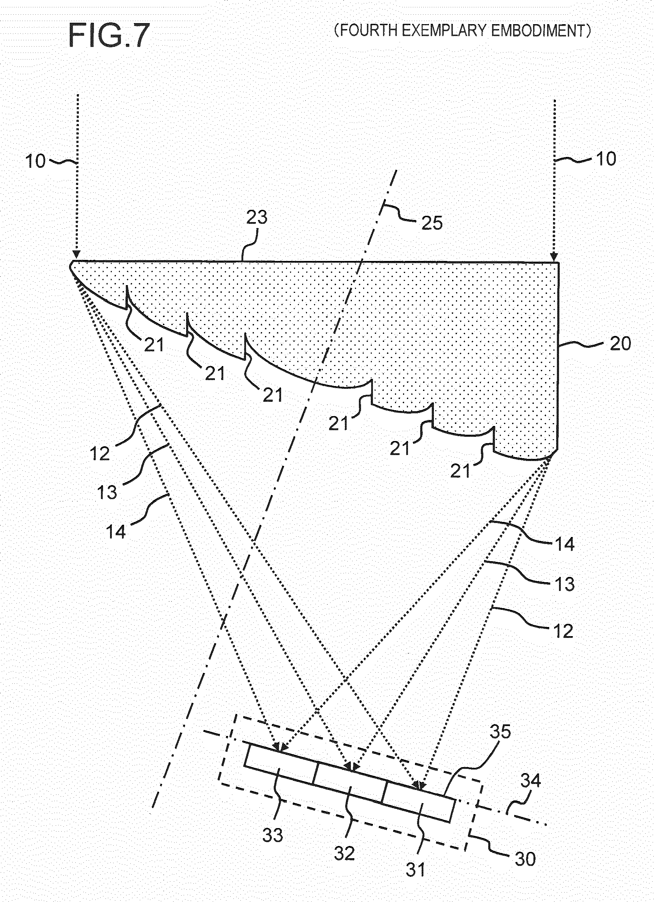

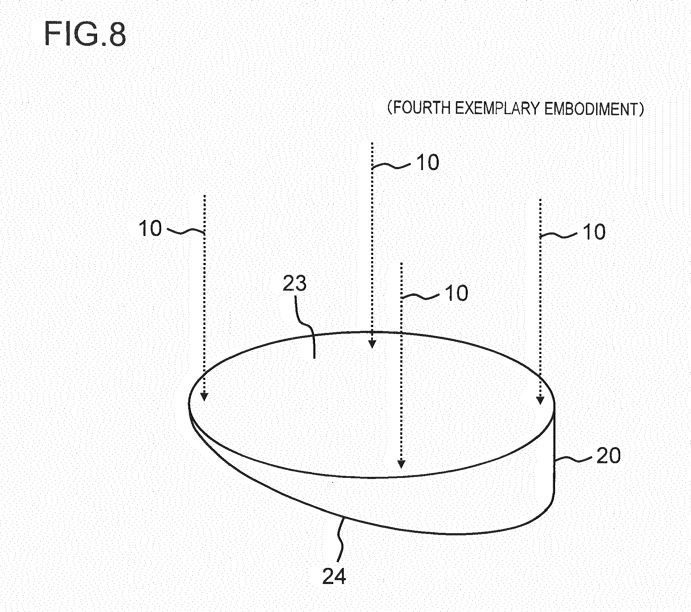

A solar power generation apparatus in accordance with a fourth exemplary embodiment of the present invention will be described with reference to drawings. Fig. 7 is a cross-sectional view taken along an optical axis schematically showing a structure of a solar power generation apparatus in accordance with the fourth exemplary embodiment of the present invention. Fig. 8 is a schematic perspective view schematically showing a structure of a Fresnel lens of the solar power generation apparatus in accordance with the fourth exemplary embodiment of the present invention.

The fourth exemplary embodiment is a variation of the third exemplary embodiment using a condenser lens 20 that is formed so that a flat surface portion 23 of the incident side is perpendicular to incident solar light 10. Meanwhile, a lens portion 24 that is an emitting side (solar cell unit 30 side) of the condenser lens 20 has a convex surface that is convex at the central portion in a state where the optical axis 25 of the condenser lens 20 is tilted at a certain angle to the solar light 10. And the lens portion 24 also has circular grooves 21 whose center is at an optical axis 25 on the convex surface just as the condenser lens (20 in Fig. 5) in the third exemplary embodiment. The other constitution is the same as in the third exemplary embodiment.

According to the fourth exemplary embodiment, an effect identical to the third exemplary embodiment is obtained. Meanwhile, in a case where the flat surface portion (23 in Fig. 5) of the incident side of the condenser lens (20 in Fig. 5) be tilted to solar light (10 in Fig. 5) as in the third exemplary embodiment (see Fig. 5), reflection loss at the flat surface portion (23 in Fig.5) may be increased; whereas the reflection loss can be suppressed by using the condenser lens 20 whose flat surface portion 23 is perpendicular to incident solar light 10 as in the fourth exemplary embodiment (see Fig. 7).

### (Fifth Exemplary Embodiment)

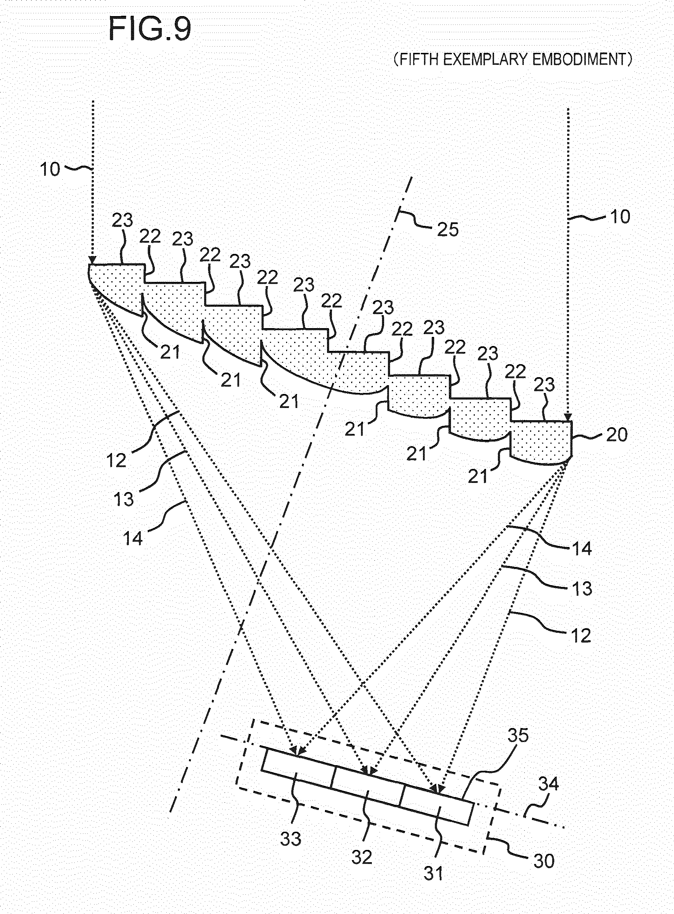

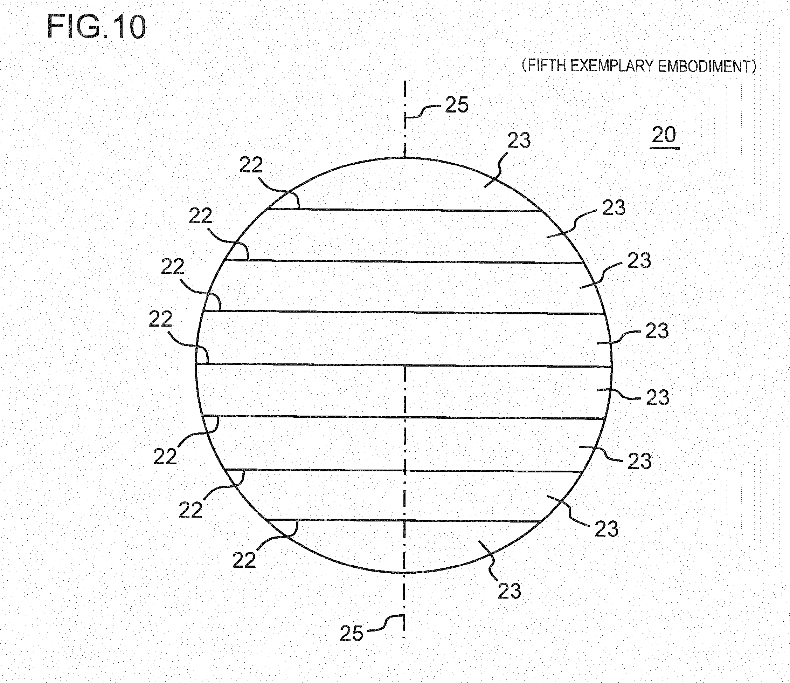

A solar power generation apparatus in accordance with the fifth exemplary embodiment will be described with reference to drawings. Fig. 9 is a cross-sectional view taken along an optical axis schematically showing a structure of a solar power generation apparatus in accordance with a fifth exemplary embodiment of the present invention. Fig. 10 is a plan view viewed from a light incident side schematically showing a structure of a Fresnel lens of the solar power generation apparatus in accordance with the fifth exemplary embodiment of the present invention.

The fifth exemplary embodiment is a variant of the third exemplary embodiment using a condenser lens 20 in which the incident side surface has a staircase (stepwise) pattern by tilting the incident side surface at a certain angle as a whole, and grooves 22 are formed so that flat surface portions 23 are perpendicular to incident light 10, and sidewall surfaces of stepped portions are parallel to the incident solar light 10. There are stripe-shaped flat surface portions 23 between the grooves 22 (see Fig. 10). Any number of stripe-shaped flat surface portions 23 of the condenser lens 20 is possible. Meanwhile, a surface of the emitting side (solar cell unit 30 side) of the condenser lens 20 is a convex surface that is convex at the central portion in a state where the optical axis 25 of the condenser lens 20 is tilted at a certain angle to the solar light 10. And the surface of the emitting side of the condenser lens 20 has concentric circular grooves 21 whose center is the optical axis 25 on the convex surface just as the condenser lens (20 in Fig. 5) in the third exemplary embodiment. The other constitution is the same as in the third exemplary embodiment.

According to the fifth exemplary embodiment, an effect similar to the third exemplary embodiment is obtained. Additionally, the fifth exemplary embodiment has a merit in which reflection loss can be suppressed, since the incident solar light 10 impinges onto the flat surface portions 23 that are perpendicular to the solar light 10. Further, the fifth exemplary embodiment has a merit in which the condenser lens 20 becomes inexpensive and light-in-weight, since the fifth exemplary embodiment needs less materials used for the condenser lens 20 than the fourth exemplary embodiment. Furthermore, since a thickness of medium through which light passes can be reduced, the fifth exemplary embodiment has a merit in which light loss in the medium can be suppressed.

Meanwhile, the condenser lens 20 in the first through fifth exemplary embodiments is not limited to a circular shape, and for instance, the condenser lens 20 with a square or rectangular shape is also possible. Furthermore, any number of solar cells having different sensitive wavelength bands that make up the solar cell unit 30 in the first through fifth exemplary embodiments is possible if it is two or more. The order of the focal positions of respective wavelength band lights and the order of the solar cells having respective sensitive wavelength bands used in the explanation mentioned above are merely shown as an example. These orders may be changed depending on a condition such as lens material, which do not change an essence of the present invention.

The exemplary embodiments and examples may include variations and modifications without departing the gist and scope of the present invention as disclosed herein and claimed as appended herewith, and furthermore based on the fundamental technical spirit. It should be noted that any combination and/or selection of the disclosed elements may fall within the claims of the present invention. That is, it should be noted that the present invention of course includes various variations and modifications that could be made by those skilled in the art according to the overall disclosures including claims, and technical spirit.

### EXPLANATIONS OF SYMBOLS

- 10: solar light (incident light)
- 11: collected light
- 12: short wavelength band light (wavelength band light)
- 13: middle wavelength band light (wavelength band light)
- 14: long wavelength band light (wavelength band light)
- 20, 120: condenser lens (optical system)
- 21, 121: groove
- 22: groove
- 23: flat surface portion
- 24: lens portion
- 25, 125: optical axis
- 30, 130: solar cell unit
- 31, 131: short wavelength band solar cell
- 32, 132: middle wavelength band solar cell
- 33, 133: long wavelength band solar cell
- 34: predetermined line
- 35: light receiving surface
- 36: substrate portion
- 37: junction portion
- 139: light receiving surface
- 141, 142, 143: power generation efficiency

## Claims

1. A solar power generation apparatus in which a solar cell unit is disposed at a focal position in an optical system, wherein
said optical system is composed of a single optical system and formulated so as to collect and spectrally separate incident light that falls in parallel to an optical axis of said optical system, and focus each of the spectrally separated wavelength band lights at a different focal position on said optical axis;
said solar cell unit includes a plurality of solar cells, each of which includes a junction portion disposed on a circumference of a substrate portion disposed along said optical axis, a surface of said junction portion forming a light receiving surface with a different sensitive wavelength band; and
said plurality of solar cells are arrayed along said optical axis, and each of said solar cells is disposed at one of said focal positions at which said wavelength band light corresponding to each said different sensitive wavelength band is focused.

2. The solar power generation apparatus according to claim 1, wherein
said substrate portion is formed as a cylindrical or columnar body disposed along said optical axis; and
said junction portion is formed in a cylindrical surface or tubular shape on a side surface(s) of said cylindrical or columnar body.

3. The solar power generation apparatus according to claim 1, wherein
said substrate portion is formed as a conical or pyramid body whose vertex is directed toward said optical system;
said junction portion is formed in a conical or pyramid shape on a side surface(s) of said conical or pyramid body.

4. The solar power generation apparatus according to any one of claims 1 to 3, wherein
said optical system is a Fresnel lens having a lens portion comprising circular concentric grooves that have sidewall surfaces extending in parallel to said incident light.

5. A solar power generation apparatus in which a solar cell unit is disposed at a focal position in an optical system, wherein
said optical system is composed of a single optical system and formulated so as to collect and spectrally separate incident light that falls in a non-parallel direction to an optical axis of said optical system, and focus each of the spectrally separated wavelength band lights at a different focal position on a predetermined line excluding said optical axis;
said solar cell unit includes a plurality of solar cells, each of which includes a planar junction portion on a surface of a substrate portion, a surface of said junction portion forming a light receiving surface with a different sensitive wavelength band; and
said plurality of solar cells are arrayed along said predetermined line, and each of said solar cells is disposed at one of said focal positions at which said wavelength band light corresponding to each said different sensitive wavelength band is focused.

6. The solar power generation apparatus according to claim 5, wherein
said optical system is a Fresnel lens having a lens portion comprising circular concentric grooves that have sidewall surfaces extending in parallel to said incident light.

7. The solar power generation apparatus according to claim 6, wherein
said Fresnel lens has a flat surface portion at an opposite surface of said lens portion;
said flat surface portion is a surface perpendicular to said incident light.

8. The solar power generation apparatus according to claim 6, wherein
said Fresnel lens has at least one step portion, each of which includes a flat surface portion perpendicular to said incident light and a groove having a sidewall surface extending in parallel to said incident light.
